# EUROPÄISCHE PATENTSCHRIFT

(11) **EP 3 383 574 B1**
(45) Veröffentlichungstag und Bekanntmachung des Hinweises auf die Patenterteilung: **04.01.2023**
(21) Anmeldenummer: 16828922.1
(22) Anmeldetag: 24.11.2016
(51) Int. Cl.: B23K 20/00, B23K 20/10, H01L 23/00, H01R 43/02

(54) **BETRIEBSVERFAHREN FÜR EINEN ULTRASCHALLDRAHTBONDER MIT AKTIVER UND PASSIVER SCHWINGUNGSDÄMPFUNG**
METHOD FOR ULTRASONIC WIRE BONDING WITH ACTIVE AND PASSIVE VIBRATION DAMPING
PROCÉDÉ DE FIXATION DE FILS ULTRASONS AVEC AMORTISSEMENT DE VIBRATIONS ACTIF ET PASSIF

(30) Priorität: 01.12.2015 DE 102015120824
(43) Veröffentlichungstag der Anmeldung: 10.10.2018
(73) Patentinhaber: Hesse GmbH, 33104 Paderborn (DE)
(72) Erfinder: HUNSTIG, Matthias, 33098 Paderborn (DE); BRÖKELMANN, Michael, 33129 Delbrück (DE)
(74) Vertreter: Wickord, Wiro
(86) Internationale Anmeldenummer: PCT/DE2016/100546
(87) Internationale Veröffentlichungsnummer: WO 2017/092730

(56) Entgegenhaltungen:
- DE-A1- 10 314 499
- DE-A1-102010 015 379
- DE-A1-102013 012 716
- US-A- 5 078 312
- Michael Brökelmann: "Active Vibration Control in Ultrasonic Wire Bonding | PowerGuru - Power Electronics Information Portal", , 17. Dezember 2014 (2014-12-17), XP055356704, Gefunden im Internet: URL:http://www.powerguru.org/active-vibrat ion-control-in-ultrasonic-wire-bonding/ [gefunden am 2017-03-21]

## Beschreibung

Die Erfindung betrifft ein Verfahren zum Betreiben eines Ultraschalldrahtbonders nach dem Oberbegriff des Patentanspruchs 1 (siehe z.B. DE 103 14 499 A1 oder US 5 078 312 A).

Um mittels eines Ultraschalldrahtbonders eine elektrisch leitende Verbindung zwischen einem Substrat und einem Bonddraht herzustellen, wird heute ein Ultraschalltransducer mittels einer Steuerung zu Schwingungen im Ultraschallbereich angeregt. Die Schwingungen werden auf ein mit dem Transducer verbundenes Bondwerkzeug so übertragen, dass das Bondwerkzeug seinerseits zu Schwingungen angeregt wird. Beispielsweise ist die Geometrie des Bondwerkzeugs und des Transducers so auf die Anregung ausgelegt, dass das Bondwerkzeug Biegeschwingungen ausführt und eine Schwingungsamplitude im Bereich einer während des Bondvorgangs an den Bonddraht angelegten Werkzeugspitze des Bondwerkzeugs ausreichend groß ausgebildet ist. Hierbei ist nach einer gewissen Prozesszeit (Bondzeit), beim Anliegen einer ausreichend hohen Bondkraft beziehungsweise bei einer ausreichenden Drahtverformung eine stoffschlüssige Verbindung zwischen dem Bonddraht und dem Substrat hergestellt. Nach dem Herstellen der stoffschlüssigen Verbindung wird die Ultraschallspannung abgeschaltet.

Es schließt sich dann beispielsweise eine vordefinierte Wartezeit an, in der das Nachschwingen des Bondwerkzeugs abklingt, und/oder der Bondkopf wird angehoben. Die Wartezeit ist hierbei typischerweise größer oder gleich der Abklingzeit der Schwingung des Bondwerkzeugs. Im Anschluss an die Wartezeit wird der Bondkopf zur Durchführung des nächsten Bonds neu positioniert. Die charakteristischen Prozessparameter, insbesondere die Bondkraft, die Drahtverformung beziehungsweise die Geschwindigkeit der Werkzeugspitze des Bondwerkzeugs werden während der Wartezeit beziehungsweise während der Abklingzeit nicht weiter erfasst.

In dem Paper "Active Vibration Control in Ultrasonic Wire Bonding", veröffentlicht in Bodo's Power Systems, Electronics in Motion and Conversion (ISSN: 1863-5598), Dezember 2014 ist eine Bondvorrichtung beschrieben sowie die Möglichkeit zur Bedämpfung beim Bonden auftretender Schadschwingungen, welche orthogonal zur Hauptschwingung auftreten. Die Schadschwingungen treten während der Anregung der Hauptschwingung auf aufgrund der nicht idealen Lagerung des Transducers.

Aus der DE 10 2013 012 716 A1 ist ein Verfahren zum Bedämpfen einer mechanischen Schwingung beim Vibrationsschweißen bekannt. Es handelt sich hierbei - anders als beim Ultraschallbonden - um eine rein induktive Last.

Aus der DE 103 14 499 A1, der US 5 078 312 A und der DE 10 2010 015 379 A1 sind weitere Verfahren zum Steuern eines Ultraschallbondprozesses beziehungsweise zur Durchführung eines Vibrationsschweißprozesses bekannt.

Aufgabe der vorliegenden Erfindung ist es, ein Betriebsverfahren für einen Ultraschalldrahtbonder so weiterzubilden, dass die Qualität der Bondverbindung verbessert beziehungsweise die Zykluszeit reduziert wird.

Zur Lösung der Aufgabe weist die Erfindung die Merkmale des Patentanspruchs 1 auf.

Der besondere Vorteil der Erfindung besteht darin, dass durch die Bedämpfung des Transducers die Bondqualität steigt und insbesondere eine Reduzierung der Streuung in Bezug auf die bei der Beurteilung der Güte der Bondverbindung wesentlichen Prozessparameter erreicht wird. Zudem kann in der zweiten Prozessphase die Abklingzeit reduziert und die Zykluszeit vermindert werden. Es ist insofern durch das erfindungsgemäße Ultraschalldrahtbondverfahren gelungen, mehr Bonds pro Zeiteinheit zu realisieren und die Wirtschaftlichkeit des Verbindungsverfahrens deutlich zu verbessern. Es ist insbesondere festgestellt worden, dass die Abklingzeit für das Bondwerkzeug je nach Prozess um mehr als 75 % reduziert werden konnte.

Erfindungsgemäß wird unter einer Änderung der Ansteuerung des Transducers entweder eine Änderung der Anregung, das heißt insbesondere das Aufprägen einer modifizierten Ultraschallspannung, oder das Beeinflussen beziehungsweise Modifizieren einer der Ansteuerung des Transducers mittels der Steuerung dienenden Schaltungsanordnung verstanden. Eine Änderung der Ansteuerung des Transducers ist demgegenüber nach dem Verständnis der Erfindung nicht herbeigeführt, wenn die Ultraschallspannung beziehungsweise die Anregung des Transducers abgeschaltet wird und insbesondere die Schaltungsanordnung unverändert bleibt. Eine Bedämpfung des Transducers erfolgt im Sinne der Erfindung passiv. Bei der passiven Bedämpfung wird Schwingungsenergie dissipiert. Beispielsweise werden hierzu dissipativ wirkende Bauelemente zum Transducer in Reihe geschaltet. Zugleich kann eine aktive Bedämpfung des Transducers erfolgen, beispielsweise durch das steuerungsseitige Aufprägen einer Gegenspannung.

Nach einer bevorzugten Ausführungsform der Erfindung werden während der zweiten Prozessphase wenigstens einzelne zur Beurteilung der Bondqualität wichtige Bondprozessparameter ermittelt und verarbeitet. Insbesondere werden die Bondkraft beziehungsweise eine Verformung des Bonddrahts beziehungsweise eine mithilfe zusätzlicher Sensorik erfasste mechanische Schwingungsamplitude des Bondwerkzeugs beziehungsweise ein Transducerstrom beziehungsweise eine Transducerspannung ermittelt. Die Erfassung der Bondprozessparameter kann modellbasiert erfolgen, ebenso können die Bondprozessparameter unmittelbar gemessen oder aus gemessenen beziehungsweise modellgestützt ermittelten Parametern berechnet werden. Vorteilhaft kann durch die Bestimmung der Bondprozessparameter eine höhere Konstanz beziehungsweise Gleichmäßigkeit der Bonds nachgewiesen beziehungsweise überwacht werden, da das Bondwerkzeug nicht unkontrolliert nachschwingt und/oder die Gegenspannung bei der aktiven Bedämpfung rechtzeitig abgeschaltet wird. Zudem wird es möglich, einen Übergangszeitpunkt für die Änderung der Ansteuerung des Transducers in Kenntnis der in der zweiten Prozessphase typischerweise zu erwartenden Bondprozessparameter zu wählen. Versuche der Anmelderin haben insofern gezeigt, dass insbesondere bei dünnen Bonddrähten und kurzen Bondzeiten eine geringe Streuung in Bezug auf die Bonds erreicht wird. Die Streuung der Bonds wird dabei nachträglich bewertet anhand von geometrischen Messgrößen (z. B. Bondfußbreite) oder Verbindungskenngrößen (z. B. Pullkraft, das heißt die Kraft, mit der man am Draht ziehen muss, um die Bondverbindung oder den Draht zu zerstören).

Nach einer Weiterbildung der Erfindung kann der Übergangszeitpunkt für den Wechsel von der ersten Prozessphase zu der zweiten Prozessphase bestimmt werden, indem wenigstens ein Bondprozessparameter aus der Gruppe der Bondprozessparameter bestimmt und mit einem gespeicherten Sollwert verglichen wird. Der Übergangszeitpunkt kann insofern individuell bestimmt beziehungsweise die Dauer der ersten Prozessphase variabel gewählt werden. In Abhängigkeit der Bondprozessparameter wird hierdurch eine weitere Reduzierung der Streuung der Bonds beziehungsweise eine Verbesserung der Bondqualität erreicht.

Nach der Erfindung wird der Transducer in der zweiten Prozessphase passiv bedämpft. Es wird hierzu wenigstens ein die Schwingungsenergie dissipierendes elektrisches Bauteil zu dem Transducer in Reihe geschaltet. Als elektrisches Bauteil kommt insbesondere ein ohmscher Widerstand (resistive Bedämpfung) beziehungsweise kommen ein Widerstand und eine Induktivität (resonante Bedämpfung) infrage. Vorteilhaft kann durch das passive Bedämpfen dem unkontrollierten Nachschwingen sehr effektiv entgegengewirkt und die Abklingzeit reduziert werden. Insbesondere wird ein Widerstandswert für den Widerstand beziehungsweise ein Induktivitätswert für die Induktivität so gewählt, dass die Abklingzeit reduziert wird. Ein optimaler Widerstandswert für den Widerstand beziehungsweise ein optimaler Induktivitätswert kann beispielsweise numerisch mithilfe eines modalen Modells des Ultraschallsystems ermittelt werden. Dazu wird die Abklingzeit des Ultraschallsystems mitsamt der zugeschalteten Bauteile berechnet. Die Bauteile werden dann so gewählt, dass die Abklingzeit möglichst gering ist.

Nach einer Weiterbildung der Erfindung kann der Transducer in der zweiten Prozessphase zugleich auch aktiv bedämpft betrieben werden. Es wird hierzu an dem Transducer eine Gegenspannung angelegt derart, dass der Transducerstrom phasenverschoben zur Gegenspannung vorgesehen ist. Die Gegenspannung wird hierbei insbesondere nur angelegt, solange das Bondwerkzeug nachschwingt.

Vorteilhaft kann durch die aktive Bedämpfung des Transducers eine ähnlich starke Schwingungsreduzierung erreicht werden wie bei der resistiven beziehungsweise resonanten Beschaltung. Darüber hinaus ist die Variabilität in Bezug auf die Bedämpfung besonders groß. Ein Phasenversatz zwischen dem Transducerstrom und der Gegenspannung im Bereich von 180° +/- 60° ist vorteilhaft. Insbesondere ist ein Phasenversatz im Bereich von 180° +/- 10° wünschenswert und ein Phasenversatz von 180° optimal.

Nach der Erfindung erfolgt die Bedämpfung des Transducers passiv. Ebenso kann nach der Erfindung eine zugleich passive und aktive Bedämpfung des Transducers vorgesehen werden.

Aus den weiteren Unteransprüchen und der nachfolgenden Beschreibung sind weitere Vorteile, Merkmale und Einzelheiten der Erfindung zu entnehmen. Dort erwähnte Merkmale können jeweils einzeln für sich oder auch in beliebiger Kombination erfindungswesentlich sein. Die Zeichnungen dienen lediglich beispielhaft der Klarstellung der Erfindung und haben keinen einschränkenden Charakter.

Es zeigen:
- Fig. 1: eine erste Ausführungsform einer Schaltungsanordnung zum passiven Bedämpfen eines Transducers in einem ersten Schaltzustand (erste Prozessphase),
- Fig. 2: die Schaltungsanordnung nach Fig. 1 in einem zweiten Schaltzustand (zweite Prozessphase),
- Fig. 3: eine zweite Ausführungsform der Schaltungsanordnung zum passiven Bedämpfen des Transducers in dem ersten Schaltzustand (erste Prozessphase),
- Fig. 4: die Schaltungsanordnung nach Fig. 3 in dem zweiten Schaltzustand (zweite Prozessphase),
- Fig. 5: ein Diagramm der Anregespannung, des Transducerstroms (Strom), der Transducerspannung und einer Geschwindigkeit der Werkzeugspitze über der Zeit,
- Fig. 6: eine exemplarische Darstellung der Abklingzeitkonstante τ über den Widerstandswert für den Widerstand für einen exemplarisch ausgewählten Transducer,
- Fig. 7: eine Prinzipdarstellung der Spannungsumkehr zum aktiven Bedämpfen der Schwingung des Transducers (nicht erfindungsgemäß),
- Fig. 8: eine Darstellung der Anregespannung, des Transducerstroms und der Geschwindigkeit der Werkzeugspitze bei dem aktiv bedämpften Transducer (nicht erfindungsgemäß) und
- Fig. 9: eine Gegenüberstellung der Nachschwingzeit für den unbedämpften Transducer, für den aktiv bedämpften Transducer (nicht erfindungsgemäß), für den passiv bedämpften Transducer und für den gleichzeitig aktiv und passiv bedämpften Transducer.

Ein zur Durchführung des erfindungsgemäßen Bondverfahrens ausgebildeter Ultraschalldrahtbonder umfasst als erfindungswesentliche Komponenten einen verfahrbar gehaltenen Bondkopf mit einem Transducer 1 und einem an dem Transducer 1 festgelegten Bondwerkzeug sowie eine Steuerung 2 zum Bereitstellen einer Anregespannung für den Transducer 1. Die Steuerung 2 ist insbesondere dazu ausgebildet, die Anregespannung so vorzugeben, dass an dem Transducer 1 eine für die Durchführung des Bondverfahrens vorteilhafte Transducerspannung vorgesehen ist. Die Steuerung 2 umfasst insofern insbesondere eine Spannungsquelle zum Aufprägen der Anregespannung. Vernachlässigt man hier zumindest näherungsweise den Einfluss der elektrischen Leitungen, entspricht die Anregespannung der Transducerspannung.

Eine stoffschlüssige, elektrisch leitende Verbindung zwischen einem Bonddraht und einem Substrat wird in einer ersten Prozessphase I hergestellt, indem der Bonddraht mit einer definierten, konstanten oder variablen Bondkraft mittels einer Werkzeugspitze des Bondwerkzeugs gegen ein Substrat gedrückt wird und dann das Bondwerkzeug zu Ultraschallschwingungen angeregt wird, indem der Transducer für ein vorbestimmtes beziehungsweise variables Zeitintervall (Bondzeit) zu Ultraschallschwingungen angeregt wird. Es kann hierbei vorgesehen sein, dass während der ersten Prozessphase I wenigstens einzelne für die Beurteilung einer Qualität des Bonds wesentliche Bondprozessparameter überwacht beziehungsweise ermittelt werden. Insbesondere können die Bondzeit, eine Verformung des Bonddrahts, die Bondkraft, die mithilfe zusätzlicher Sensorik erfasste mechanische Schwingungsamplitude des Bondwerkzeugs, der Transducerstrom beziehungsweise die Transducerspannung sowie die Anregespannung überwacht beziehungsweise modellgestützt oder messtechnisch ermittelt oder berechnet werden.

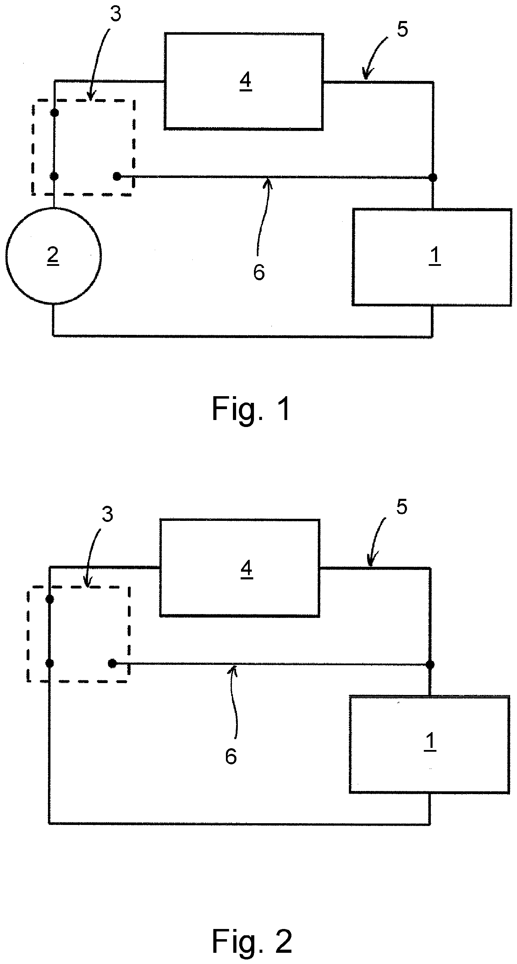

Um ein Nachschwingen des Bondwerkzeugs nach dem Ende des ersten Teilprozesses I zu reduzieren, kann der Transducer 1 in einer zweiten Prozessphase II passiv bedämpft werden. Eine erste Ausführungsform einer entsprechenden Schaltungsanordnung zum passiven Bedämpfen des Transducers 1 ist in den Fig. 1 und 2 dargestellt. Insbesondere ist vorgesehen, dass die Ansteuerung des Transducers 1 geändert wird, um die passive Bedämpfung zu realisieren. Erfindungsgemäß ist dabei vorgesehen, dass der Transducer 1 über zwei parallele Leiter 5, 6 mit der Steuerung 2 verbunden ist. Ein erster Leiter ist dabei nach Art eines Widerstandsleiters 5 ausgebildet. In dem Widerstandsleiter 5 ist ein ohmscher Widerstand 4 vorgesehen. Parallel zu dem Widerstandsleiter 5 ist ein Parallelleiter 6 vorgesehen, welcher auf einen Widerstand verzichtet. Zusätzlich ist den parallelen Leitern 5, 6 ein Schaltelement 3 zugeordnet. Das Schaltelement 3 ist so ausgebildet, dass in einem ersten Schaltzustand die Ansteuerung 2 über den Parallelleiter 6 mit dem Transducer 1 verbunden ist. In einem zweiten Schaltzustand des Schaltelements 3 erfolgt die Verbindung des Transducers 1 mit der Steuerung 2 über den Widerstandsleiter 5.

Das erfindungsgemäße Ultraschalldrahtbondverfahren sieht nun vor, dass während der ersten Prozessphase I das Schaltelement 3 in dem ersten Schaltzustand vorgesehen ist und der Transducer 1 über die Parallelleiter 6 mit der Steuerung 2 verbunden wird. Nach dem Herstellen der stoffschlüssigen, elektrisch leitenden Verbindung zwischen dem Bonddraht und dem Substrat wird die Ansteuerung für den Transducer 1 geändert, indem das Schaltelement 3 in den zweiten Schaltzustand verbracht wird. Der Transducer 1 ist dann über den Widerstandsleiter 5 mit der Steuerung 2 verbunden. Die resistive Beschaltung des Transducers 1 ist insofern nur während der zweiten Prozessphase II vorgesehen.

In der zweiten Prozessphase II wird die Schwingungsenergie beim Abklingen nicht zum überwiegenden Teil im Transducer 1, den Reibkontakten und der Bondverbindung, sondern im Widerstand 4 dissipiert. Der Widerstand 4 kann dabei ortsfern vom Transducer 1 beziehungsweise der Steuerung 2 vorgesehen werden. Durch die Dissipation der Schwingungsenergie im Widerstand 4 verkürzt sich die Abklingzeit beziehungsweise dem Nachschwingen des Bondwerkzeugs wird wirksam entgegengewirkt.

Nach einer Variante der ersten Ausführungsform der erfindungsgemäßen Schaltungsanordnung kann zusätzlich zu dem Widerstand 4 eine Induktivität in dem Widerstandsleiter 5 vorgesehen werden. Der Widerstand 4 und die Induktivität bilden dann ein elektrisches Netzwerk, welches dem Widerstandsleiter 5 zugeordnet ist. Induktivitätswert und Widerstandswert können dann so gewählt werden, dass die Abklingzeitkonstante minimiert wird.

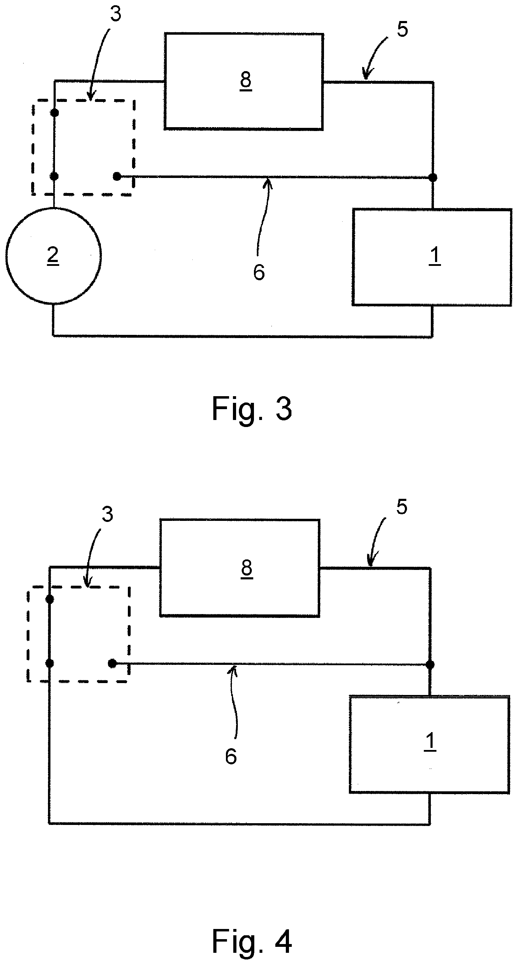

Nach einer zweiten Ausführungsform der erfindungsgemäßen Schaltungsanordnung nach den Fig. 3 und 4 ist dem Widerstandsleiter 5 nunmehr ein elektrisches Netzwerk 8 zugeordnet, welches exemplarisch einen nicht einzeln dargestellten Widerstand und eine Induktivität (ebenfalls nicht dargestellt) umfasst und den Transducer 1 dauerhaft mit der Steuerung 2 verbindet. Parallel zum Widerstandsleiter ist der Parallelleiter 6 vorgesehen zum Verbinden der Steuerung 2 mit dem Transducer 1. Dem Parallelleiter 6 ist hierbei das Schaltelement 3 funktional allein so zugeordnet, dass wahlweise die Verbindung der Steuerung 2 mit dem Transducer 1 über die Parallelleitung 6 hergestellt oder unterbrochen ist. Während der Widerstandsleiter 5 in dem ersten Schaltzustand nach Fig. 3 im Wesentlichen ohne Funktion ist und der Transducer unbedämpft betrieben wird (erste Prozessphase I), wird durch die Unterbrechung des Parallelleiters 6 in der zweiten Prozessphase II (Fig. 4) der Transducer 1 über das elektrische Netzwerk 8 bedämpft.

Statt des elektrischen Netzwerks 8 kann dem Widerstandsleiter 5 nach einer Variante der zweiten Ausführungsform der Schaltungsanordnung wie in dem Beispiel nach den Fig. 1 und 2 gezeigt allein ein einzelner Widerstand 4 zugeordnet sein. Ebenso kann das elektrische Netzwerk 8 andere beziehungsweise weitere elektrische Bauelemente vorsehen. Wesentlich ist insofern allein, dass das elektrische Netzwerk 8 eine in Bezug auf den Transducer 4 dämpfende Wirkung bereitstellt.

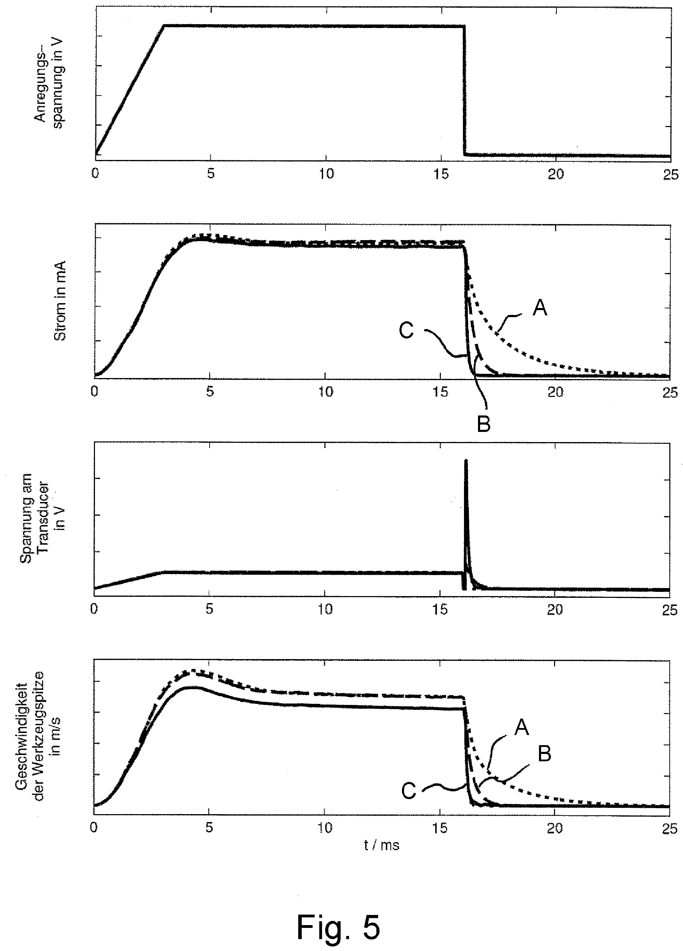

In dem Diagramm nach Fig. 5 werden die Amplituden der Anregespannung, welche seitens der Steuerung 2 zur Verfügung gestellt wird, des Transducerstroms, der Transducerspannung und der Geschwindigkeit der Werkzeugspitze im Zeitverlauf dargestellt. Erkennbar ist insbesondere, dass beim Abschalten der Anregespannung bei einem Verzicht auf den Widerstand 4 (Kurve A) eine Abklingzeit von etwa 8 ms zu berücksichtigen sein wird. Bei einem ersten Widerstandswert (Kurve B) reduziert sich die Abklingzeit um etwa 75 % auf zirka 2 ms. Bei einem zweiten Widerstandswert (Kurve C) für den Widerstand 4 reduziert sich die Abklingzeit weiter um mehr als 90 % auf weniger als 1 ms. Es ist hierbei der Widerstandswert des Widerstands 4 für die Kurve C größer gewählt als für die Kurve B. Ein sehr ähnlicher Verlauf ist auch in Bezug auf die Geschwindigkeit der Werkzeugspitze zu erkennen. Hier reduziert sich die Geschwindigkeit der Werkzeugspitze beim Vorsehen des ersten Widerstandswerts (Kurve B) gegenüber der Geschwindigkeit im unbedämpften Fall (Kurve A) signifikant. Eine weitere Reduzierung wird im Falle eines Vorsehens eines zweiten Widerstandswerts (Kurve C) erreicht.

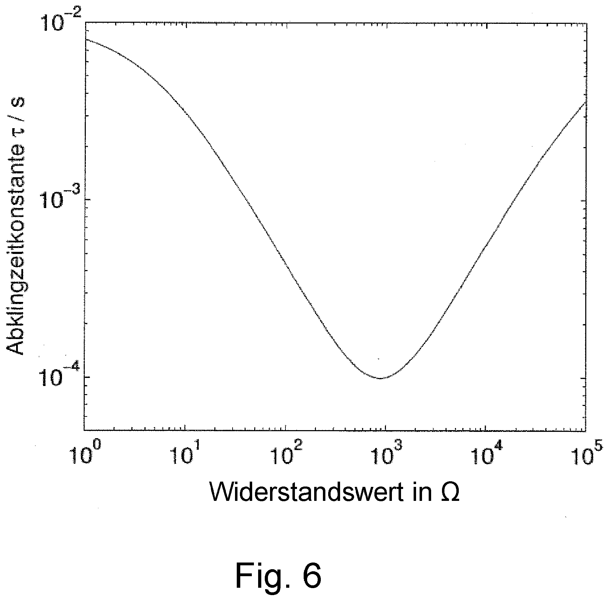

Ein Maß für die Reduzierung der Abklingzeit ist insbesondere der Widerstandswert. Hier gilt, dass ein optimaler Widerstandswert für die Bedämpfung des Transducers 1 bestimmt werden kann. Fig. 6 zeigt prinzipiell, wie ein Widerstandswert für den Widerstand 4 optimal bestimmt wird. Die Bestimmung erfolgt insbesondere numerisch mittels eines modalen Modells des Ultraschallsystems so, dass eine Abklingzeitkonstante möglichst klein eingestellt ist. Alternativ kann ein geeigneter Widerstandswert beispielsweise experimentell bestimmt werden, in dem die Abklingzeitkonstante des Systems mit verschiedenen Widerständen gemessen und ein Widerstandswert gewählt wird, mit dem eine möglichst geringe Abklingzeitkonstante erreicht wird.

Die Abklingzeitkonstante τ beschreibt dabei die Zeit, nach der die Schwingungsamplitude von 1 auf 1/e, das heißt auf 36,79 % gesunken ist. Nach 3τ ist die Schwingungsamplitude auf 1/e³ (4,96 %) gesunken. Nach 5τ reduziert sich die Schwingungsamplitude auf 0,67 %. Wird die Abklingzeit so definiert, dass nach dieser Zeit weniger als 1% der Ursprungsamplitude vorliegt, kann diese beispielsweise als 4,7τ bestimmt werden.

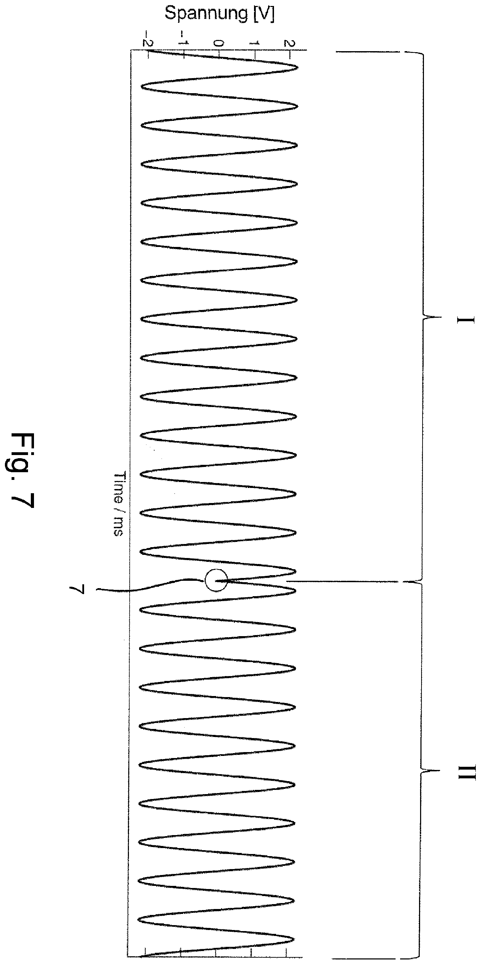

Nach einem weiteren, nicht erfindungsgemäßen Ausführungsbeispiel kann die Bedämpfung des Transducers 1 aktiv erfolgen. Es wird hierzu an dem Transducer 1 in der zweiten Prozessphase II eine Gegenspannung aufgeprägt. Fig. 7 zeigt hierzu exemplarisch, wie die Spannung in einem zwischen der ersten Prozessphase I und der zweiten Prozessphase II vorgesehenen Übergangszeitpunkt 7 invertiert wird. Es ist insbesondere so, dass zum optimalen Bedämpfen des Transducers 1 ein Phasenversatz zwischen dem Transducerstrom und der Gegenspannung im Bereich von 180° vorgesehen wird.

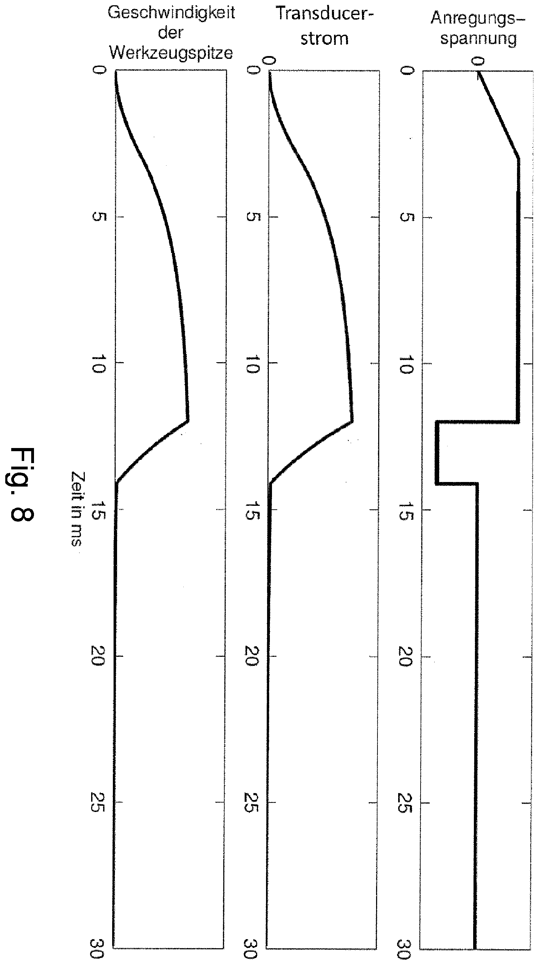

Fig. 8 zeigt für den Fall der aktiven Bedämpfung des Transducers 1 den zeitlichen Verlauf der Amplituden der Anregespannung, des Transducerstroms und der Geschwindigkeit der Werkzeugspitze. Eine negative Amplitude beschreibt dabei einen Phasenversatz von 180° gegenüber einer positiven Amplitude. Es ist insbesondere zu sehen, dass die Gegenspannung nur bis zum Abklingen der Transducerschwingung anliegt und anschließend auf Null geändert wird. Während des Abklingens der Schwingung reduzieren sich der Transducerstrom und die Geschwindigkeit der Werkzeugspitze entsprechend signifikant.

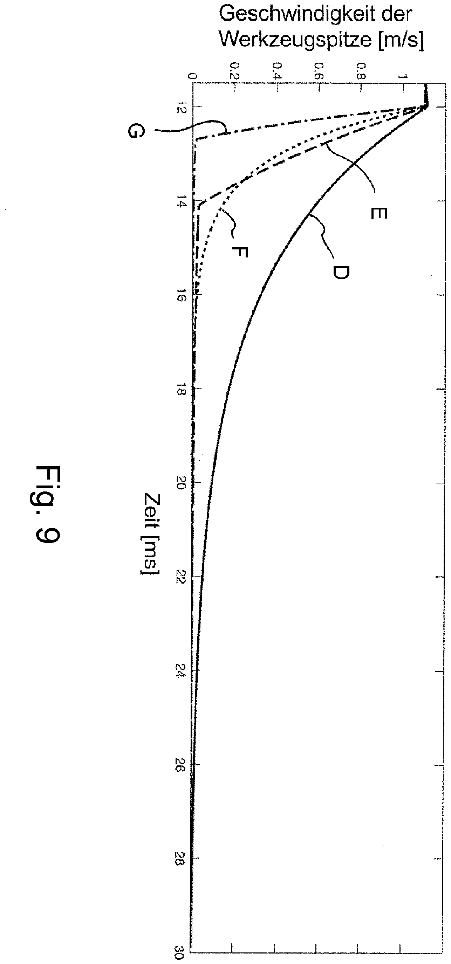

Fig. 9 zeigt eine Gegenüberstellung der Amplitude der Geschwindigkeit der Werkzeugspitze für den Fall, dass der Transducer 1 nicht bedämpft betrieben wird (Kurve D), dass der Transducer 1 aktiv bedämpft betrieben wird (Kurve E), dass der Transducer 1 passiv bedämpft betrieben wird (Kurve F) und dass der Transducer 1 gleichzeitig aktiv und passiv bedämpft wird (Kurve G). Es ist erkennbar, dass die aktive und die passive Bedämpfung (Kurven E und F) die Abklingzeit für den Transducer 1 sehr signifikant reduzieren und dass eine weitere Optimierung insbesondere bei der gleichzeitigen aktiven und passiven Bedämpfung (Kurve G) des Transducers 1 erwirkt wird.

Gleiche Bauteile und Bauteilfunktionen sind durch gleiche Bezugszeichen gekennzeichnet.

## Patentansprüche

1. Verfahren zum Betreiben eines Ultraschalldrahtbonders, wobei der Ultraschalldrahtbonder einen Bondkopf mit einem Bondwerkzeug und einem Transducer (1) zum Anregen von Ultraschallschwingungen in dem Bondwerkzeug sowie eine Steuerung (2) für den Transducer (1) aufweist, umfassend eine erste Prozessphase I, in der ein Bonddraht an ein Substrat gebondet wird, indem der Bonddraht mittels einer Werkzeugspitze des Bondwerkzeugs mit einer Bondkraft gegen das Substrat gedrückt wird und dann zum Herstellen einer stoffschlüssigen Verbindung zwischen dem Bonddraht und dem Substrat das Bondwerkzeug zu Ultraschallschwingungen angeregt wird, indem der Transducer (1) für eine vorbestimmte oder variable Bondzeit zu Schwingungen angeregt wird, **dadurch gekennzeichnet, dass** in einer anschließenden zweiten Prozessphase II die Ansteuerung des Transducers (1) geändert und einem Nachschwingen des Bondwerkzeugs entgegengewirkt wird, wobei der Transducer (1) in der zweiten Prozessphase II passiv bedämpft betrieben wird, indem wenigstens ein die Schwingungsenergie dissipierendes elektrisches Bauteil zu dem Transducer (1) in Reihe geschaltet wird, und dass die Anregung des Transducers (1) abgeschaltet wird.

2. Verfahren nach Anspruch 1, **dadurch gekennzeichnet, dass** während der zweiten Prozessphase II die Bondkraft und/oder eine Verformung des Bonddrahts und/oder eine Geschwindigkeit der Werkzeugspitze des Bondwerkzeugs und/oder eine mithilfe zusätzlicher Sensorik erfasste mechanische Schwingungsamplitude des Bondwerkzeugs und/oder ein Transducerstrom und/oder eine Transducerspannung bestimmt und/oder verarbeitet werden.

3. Verfahren nach Anspruch 1 oder 2, **dadurch gekennzeichnet, dass** als elektrisches Bauteil ein ohmscher Widerstand (4) zu dem Transducer (1) in Reihe geschaltet wird.

4. Verfahren nach einem der Ansprüche 1 bis 3, **dadurch gekennzeichnet, dass** als elektrisches Bauteil der ohmsche Widerstand (4) und eine Induktivität zu dem Transducer (1) in Reihe geschaltet werden.

5. Verfahren nach Anspruch 3 oder 4, **dadurch gekennzeichnet, dass** ein Widerstandswert für den Widerstand (4) und/oder ein Induktivitätswert für die Induktivität so bestimmt werden, dass eine Abklingzeit für das Bondwerkzeug reduziert wird.

6. Verfahren nach einem der Ansprüche 1 bis 5, **dadurch gekennzeichnet, dass** der Transducer (1) in der zweiten Prozessphase II aktiv bedämpft betrieben wird, indem an dem Transducer 1 eine Gegenspannung angelegt wird, wobei die Gegenspannung phasenverschoben zu dem Transducerstrom vorgesehen ist.

7. Verfahren nach Anspruch 6, **dadurch gekennzeichnet, dass** ein Phasenversatz von Transducerstrom und Gegenspannung im Bereich von 180° +/- 60° anliegt.

8. Verfahren nach Anspruch 6 oder 7, **dadurch gekennzeichnet, dass** die Gegenspannung nur anliegt, solange das Bondwerkzeug nachschwingt.

9. Verfahren nach einem der Ansprüche 1 bis 8, **dadurch gekennzeichnet, dass** ein Übergangszeitpunkt (7) für den Wechsel von der ersten Prozessphase I in die zweite Prozessphase II ermittelt wird, indem wenigstens ein Bondprozessparameter aus der Gruppe Bondzeit, Verformung des Bonddrahts, Bondkraft, Geschwindigkeit der Werkzeugspitze des Bondwerkzeugs, Transducerstrom und/oder eine mithilfe zusätzlicher Sensorik erfasste mechanische Schwingungsamplitude des Bondwerkzeugs und/oder Transducerspannung während der ersten Prozessphase I bestimmt und mit einem gespeicherten Sollwert verglichen wird.

## Claims

1. Method for operating an ultrasound wire bonder, wherein the ultrasound wire bonder has a bonding head, comprising a bonding tool and a transducer (1) for exciting ultrasound oscillations in the bonding tool, and a control system (2) for the transducer (1), comprising a first process phase I, in which a bonding wire is bonded to a substrate in that the bonding wire is pressed against the substrate with a bonding force by means of a tool tip of the bonding tool and subsequently ultrasound oscillations are excited in the bonding tool to produce a material connection between the bonding wire and the substrate, in that the oscillations are excited in the transducer (1) for a predetermined or variable bonding time, **characterised in that**, in a subsequent, second process phase II, the actuation of the transducer (1) is altered and reverberation of the bonding tool is countered, the transducer (1) being operated with passive damping in the second process phase II **in that** at least one electrical component which dissipates the oscillation energy is connected in series with the transducer (1) and **in that** the excitation of the transducer (1) is switched off.

2. Method according to claim 1, **characterised in that**, during the second process phase II, the bonding force and/or a deformation of the bonding wire and/or a speed of the tool tip of the bonding tool and/or a mechanical oscillation amplitude of the bonding tool determined using additional sensors and/or a transducer current and/or a transducer voltage are determined and/or processed.

3. Method according to either claim 1 or claim 2, **characterised in that**, as an electrical component, an ohmic resistor (4) is connected in series with the transducer (1).

4. Method according to any of claims 1 to 3, **characterised in that**, as an electrical component, the ohmic resistor (4) and an inductor are connected in series with the transducer (1).

5. Method according to either claim 3 or claim 4, **characterised in that** a resistance of the resistor (4) and/or an inductance of the inductor are determined in such a way that a decay time for the bonding tool is reduced.

6. Method according to any of claims 1 to 5, **characterised in that** the transducer (1) is operated with active damping in the second process phase II **in that** a counter voltage is applied to the transducer 1, the counter voltage being provided phase-shifted with respect to the transducer current.

7. Method according to claim 6, **characterised in that** a phase offset of the transducer current and the counter voltage is in a range of 180° ± 60°.

8. Method according to either claim 6 or claim 7, **characterised in that** the counter voltage is only applied as long as the bonding tool is reverberating.

9. Method according to any of claims 1 to 8, **characterised in that** a transition point (7) for the change from the first process phase I to the second process phase II is determined **in that** at least one bonding process parameter, from the group consisting of bonding time, deformation of the bonding wire, bonding force, speed of the tool tip of the bonding tool, transducer current and/or a mechanical oscillation amplitude of the bonding tool determined using additional sensors and/or transducer voltage, is determined during the first process phase I and compared with a stored target value.

## Revendications

1. Procédé pour faire fonctionner un dispositif de fixation de fils à ultrasons, le dispositif de fixation de fils à ultrasons présentant une tête de fixation avec un outil de fixation et un transducteur (1) pour exciter des vibrations ultrasonores dans l'outil de fixation ainsi qu'une commande (2) pour le transducteur (1), comprenant une première phase de processus I dans laquelle un fil de fixation est fixé à un substrat en pressant le fil de fixation contre le substrat avec une force de fixation au moyen d'une pointe d'outil de l'outil de fixation et en soumettant ensuite l'outil de fixation à des vibrations ultrasonores pour créer une liaison par complémentarité de matières entre le fil de fixation et le substrat, par le fait que le transducteur (1) est excité en vibrations pendant un temps de fixation prédéterminé ou variable, **caractérisé en ce que**, dans une deuxième phase de processus II qui suit, la commande du transducteur (1) est modifiée et une vibration postérieure de l'outil de fixation est contrecarrée, le transducteur (1) étant utilisé de manière passivement amortie dans la deuxième phase de processus II, par le fait qu'au moins un composant électrique dissipant l'énergie de vibration est monté en série avec le transducteur (1) et que l'excitation du transducteur (1) est coupée.

2. Procédé selon la revendication 1, **caractérisé en ce que**, pendant la deuxième phase de processus II, on détermine et/ou on traite la force de fixation et/ou une déformation du fil de fixation et/ou une vitesse de la pointe d'outil de l'outil de fixation et/ou une amplitude de vibration mécanique de l'outil de fixation détectée à l'aide de capteurs supplémentaires et/ou un courant de transducteur et/ou une tension de transducteur.

3. Procédé selon la revendication 1 ou 2, **caractérisé en ce qu'**une résistance ohmique (4) est montée en série avec le transducteur (1) en tant que composant électrique.

4. Procédé selon l'une des revendications 1 à 3, **caractérisé en ce que** la résistance ohmique (4) et une inductance sont montées en série avec le transducteur (1) en tant que composant électrique.

5. Procédé selon la revendication 3 ou 4, **caractérisé en ce qu'**une valeur de résistance pour la résistance (4) et/ou une valeur d'inductance pour l'inductance sont déterminées de manière à réduire un temps de décroissance pour l'outil de fixation.

6. Procédé selon l'une des revendications 1 à 5, **caractérisé en ce que** le transducteur (1) est utilisé de manière activement amortie dans la deuxième phase de processus II, par le fait qu'une contre-tension est appliquée au transducteur 1, la contre-tension étant prévue déphasée par rapport au courant de transducteur.

7. Procédé selon la revendication 6, **caractérisé en ce qu'**un déphasage entre le courant de transducteur et la contre-tension est appliqué dans la plage de 180° ±60°.

8. Procédé selon la revendication 6 ou 7, **caractérisé en ce que** la contre-tension n'est appliquée que tant que l'outil de fixation continue de vibrer.

9. Procédé selon l'une des revendications 1 à 8, **caractérisé en ce qu'**un instant de transition (7) pour le passage de la première phase de processus I à la deuxième phase de processus II est déterminé en déterminant pendant la première phase de processus I au moins un paramètre de processus de fixation parmi le groupe comprenant le temps de fixation, la déformation du fil de fixation, la force de fixation, la vitesse de la pointe d'outil de l'outil de fixation, le courant de transducteur et/ou une amplitude de vibration mécanique de l'outil de fixation détectée à l'aide de capteurs supplémentaires et/ou une tension de transducteur, et en le comparant à une valeur de consigne mémorisée.
